# FASCICULE DE BREVET EUROPEEN

(11) **EP 1 559 192 B1**
(45) Date de publication et mention de la délivrance du brevet: **01.03.2006**
(21) Numéro de dépôt: 03786000.4
(22) Date de dépôt: 28.10.2003
(51) Int. Cl.: H03F 1/32, H04B 7/005

(54) **PROCEDE ET DISPOSITIF D'APPRENTISSAGE D'UN DISPOSITIF DE LINEARISATION D'UN AMPLIFICATEUR RF, ET TERMINAL MOBILE INCORPORANT UN TEL DISPOSITIF**
VERFAHREN UND EINRICHTUNG ZUM TRAINIEREN EINER HF-VERSTÄRKERLINEARISIERUNGSEINRICHTUNG UND MOBILES ENDGERÄT DAMIT
METHOD AND DEVICE FOR TRAINING AN RF AMPLIFIER LINEARIZATION DEVICE, AND MOBILE TERMINAL INCORPORATING SAME

(30) Priorité: 05.11.2002 FR 0213825
(43) Date de publication de la demande: 03.08.2005
(73) Titulaire: Eads Telecom, 78180 Montigny Le Bretonneux (FR)
(72) Inventeur: TOUCHAIS, Sandrine, f-91400 Orsay (FR); CHECOURY, Xavier, F-75018 Paris (FR)
(74) Mandataire: Verdure, Stéphane
(86) Numéro de dépôt international: PCT/FR2003/003204
(87) Numéro de publication internationale: WO 2004/045066

(56) Documents cités:
- GB-A- 2 321 574
- US-A- 5 559 807

## Description

La présente invention concerne la linéarisation des amplificateurs de puissance radiofréquence (RF). Elle trouve des applications, en particulier, dans les émetteurs RF des terminaux mobiles des systèmes de radiocommunications numériques. Elle peut aussi s'appliquer dans les émetteurs RF des stations de base en particulier lors du premier démarrage d'une telle station.

Dans les systèmes de radiocommunication numériques actuels, on cherche à transmettre des informations avec un débit maximal dans une bande de fréquence RF donnée qui est affectée à un canal de transmission (ci-après canal radio). Pour ce faire, les modulations utilisées depuis quelques années comportent une composante de modulation de phase ou de fréquence et une composante de modulation d'amplitude.

De plus, des canaux radio coexistent dans une bande de fréquence déterminée allouée au système. Chaque canal radio est subdivisé en canaux logiques par division de temps. Dans chaque intervalle de temps ("Time Slot" en anglais), il est émis un groupe de symboles appelé salve ou paquet ("Burst" en anglais).

Il est nécessaire de veiller à ce que, à chaque instant, le niveau de puissance émis dans chaque canal radio ne brouille pas les communications dans un canal radio adjacent. Ainsi, des spécifications imposent que le niveau de puissance d'un signal RF émis dans un canal radio déterminé soit, dans un canal radio adjacent, inférieur par exemple de 60 dB (décibels), au niveau de puissance du signal RF émis dans ledit canal radio déterminé.

Il s'avère donc nécessaire que le spectre du signal à émettre, qui résulte notamment du type de la modulation employée et du débit binaire, ne soit pas déformé par l'émetteur RF. En particulier, il faut que l'émetteur RF présente une caractéristique de la puissance de sortie en fonction de la puissance d'entrée, qui soit linéaire.

Toutefois, l'amplificateur de puissance radiofréquence (ci-après amplificateur RF) présent dans l'émetteur RF a une caractéristique linéaire à faible puissance de sortie mais non linéaire dès que la puissance dépasse un certain seuil. On sait aussi que le rendement de l'amplificateur RF est d'autant meilleur que l'on travaille dans une zone proche de la saturation c'est-à-dire en régime non linéaire. Ainsi la nécessité de linéarité et la nécessité de rendement élevé (pour économiser la charge de la batterie) obligent à utiliser des techniques de linéarisation pour corriger les non-linéarités de l'amplificateur RF. Deux des techniques les plus couramment employées sont la prédistorsion adaptative en bande de base et la boucle cartésienne en bande de base.

Dans la technique de la boucle cartésienne, le signal à émettre est généré en bande de base au format I et Q. Par ailleurs, un coupleur suivi d'un démodulateur permettent de prélever une partie du signal RF émis et de le transposer en bande de base (conversion descendante), au format I et Q. Ce signal en bande de base est comparé au signal en bande de base à émettre. Un signal d'erreur résultant de cette comparaison attaque un modulateur, qui assure la transposition vers le domaine des radiofréquences (conversion montante). Le signal en sortie du modulateur est amplifié par un amplificateur RF qui délivre le signal RF émis.

Dans la technique de prédistorsion adaptative en bande de base, le signal à émettre est généré en bande de base, en format I et Q, et pré-distordu via un dispositif de prédistorsion. Puis, ce signal est transposé vers le domaine RF grâce à un modulateur RF. Ensuite, il est amplifié dans un amplificateur RF. Un coupleur suivi d'un démodulateur RF permettent de prélever une partie du signal RF émis et de le transposer en bande de base, au format I, Q. Ce signal démodulé en bande de base est numérisé et comparé avec le signal en bande de base à émettre. Une adaptation des coefficients de prédistorsion, réalisée pendant une phase d'apprentissage du dispositif de prédistorsion, permet de faire converger le signal au format I et Q démodulé vers le signal au format I et Q à émettre.

Dans ces deux techniques, une partie du signal émis est prélevée en sortie de l'amplificateur RF afin de le comparer au signal à émettre. Il en résulte que la linéarité n'est pas obtenue immédiatement mais seulement après un certain temps, nécessaire à la convergence du dispositif de linéarisation. L'apprentissage du dispositif de linéarisation nécessite la transmission d'une séquence de données particulière ou séquence d'apprentissage. Cette remarque s'applique certes plus à la prédistorsion adaptative qu'à la boucle cartésienne, même si cette demière nécessite, pour assurer sa stabilité, des ajustements initiaux de phase et de niveaux d'amplitude assimilable à un apprentissage.

La méthode d'apprentissage divulguée dans le document WO 94/10765, repose ainsi sur l'émission par les émetteurs du système de séquences particulières, dites séquences d'apprentissage de linéarisation, pendant des phases d'apprentissage de linéarisation. Plus particulièrement, des séquences d'apprentissage sont émises de façon isolée dans des intervalles de temps formant un canal logique particulier des canaux radio, qui est dédié uniquement à la linéarisation. Cependant cette méthode présente plusieurs inconvénients. Tout d'abord, elle nécessite une synchronisation préalable de tous les émetteurs pour que ceux-ci émettent leur séquence d'apprentissage de linéarisation respective dans le canal logique dédié à la linéarisation. De plus, aucune transmission de données ne peut avoir lieu dans les intervalles de temps de ce canal logique. En outre, au début de chaque émission ou en cas de changement de canal radio, l'émetteur est obligé d'attendre l'intervalle de temps suivant du canal logique dédié à la linéarisation, à moins de complexifier considérablement le système. C'est pourquoi l'espacement temporel entre deux intervalles de temps dudit canal logique ne peut dépasser la seconde, afin de garantir une certaine qualité de service (QoS). Cette technique est donc très préjudiciable à l'efficacité spectrale du système de radiocommunications.

D'une façon générale, il existe des systèmes de radiocommunications dont la structure de trame n'est pas adaptée à la transmission d'une séquence d'apprentissage, par exemple lorsque aucun intervalle de temps spécifique n'a été prévu à cet effet lors de la définition de la structure de trame.

Afin de pallier tout ou partie des inconvénients de l'art antérieur précité, un premier aspect de l'invention concerne un procédé d'apprentissage d'un dispositif de linéarisation d'un amplificateur radiofréquence qui est compris dans un émetteur radiofréquence d'un terminal mobile d'un système de radiocommunications comprenant un réseau fixe et des terminaux mobiles, lequel émetteur est adapté pour émettre des salves selon une structure de trame déterminée, chaque salve comprenant des symboles appartenant à un alphabet de symboles déterminé. Le procédé comprend les étapes consistant à :
a) générer une séquence d'apprentissage de linéarisation comprenant un nombre déterminé N de symboles, où N est un nombre entier déterminé ;
b) émettre la séquence d'apprentissage de linéarisation au moyen de l'émetteur radiofréquence, dans certaines au moins des salves émises par celui-ci ;
c) comparer la séquence d'apprentissage de linéarisation émise à la séquence d'apprentissage de linéarisation générée afin d'entraîner ledit dispositif de linéarisation.

Avantageusement, à l'étape b), la séquence d'apprentissage de linéarisation est comprise dans une séquence de symboles prévue en outre pour permettre le réglage de paramètres de la chaîne de transmission entre ledit premier équipement et un second équipement du système de radiocommunications avec lequel ledit premier équipement communique.

Par chaîne de transmission, on entend l'ensemble des composants qui prennent part à une communication bidirectionnelle entre un premier et un second équipement, typiquement un terminal mobile et la station de base avec laquelle il communique.

De préférence, la séquence de symboles prévue pour permettre le réglage de paramètres est une séquence de symboles prévue pour permettre la commande dynamique du gain d'un amplificateur à gain variable d'un récepteur radiofréquence d'un second équipement du système de radiocommunications avec lequel le premier équipement communique.

Dit autrement, la séquence d'apprentissage est émise à l'étape b) à l'intérieur d'un intervalle de temps réservé dans la structure de trame pour l'émission d'une séquence de CAG (Contrôle automatique de gain), et elle assure en même temps le rôle d'une telle séquence de CAG.

Ainsi, on utilise pour l'émission de la séquence d'apprentissage le temps d'émission d'une séquence de symboles nécessaire à d'autres fins, en l'occurrence une séquence de CAG émise pour permettre la commande dynamique de la puissance d'émission du terminal mobile en réception.

Selon un avantage, la valeur des symboles de la séquence de CAG n'est soumise à aucune contrainte (la séquence de CAG doit simplement être connue du réseau fixe). Il y a donc toute liberté pour choisir les symboles de la séquence, ou du moins une partie des symboles de la séquence, de manière que ces symboles forment une séquence d'apprentissage satisfaisante.

Selon un autre avantage, la récurrence de la séquence de CAG est adaptée aux besoins de l'apprentissage du dispositif de linéarisation de l'amplificateur RF. En effet, la séquence de CAG est en général émise en début de trame, puis lors d'un changement de canal logique, lors d'un changement de fréquence RF et/ou lors d'un changement de palier de puissance. Or c'est sensiblement à ces moments-là aussi que la séquence d'apprentissage de linéarisation a besoin d'être émise.

Un deuxième aspect de l'invention concerne un dispositif d'apprentissage d'un dispositif de linéarisation d'un amplificateur radiofréquence qui est compris dans un émetteur radiofréquence d'un premier équipement d'un système de radiocommunications, lequel émetteur est adapté pour émettre des salves selon une structure de trame déterminée, chaque salve comprenant des symboles appartenant à un alphabet de symboles déterminé. Le dispositif comprend :
a) des moyens pour générer une séquence d'apprentissage de linéarisation comprenant un nombre déterminé N de symboles, où N est un nombre entier déterminé ;
b) des moyens pour émettre la séquence d'apprentissage de linéarisation au moyen de l'émetteur dans certaines au moins des salves émises par celui-ci ;
c) des moyens pour comparer la séquence d'apprentissage de linéarisation émise à la séquence d'apprentissage de linéarisation générée afin d'entraîner ledit dispositif de linéarisation.

Avantageusement, la séquence d'apprentissage de linéarisation est comprise dans une séquence de symboles prévue en outre pour permettre le réglage de paramètres de la chaîne de transmission entre ledit premier équipement et un second équipement du système de radiocommunications avec lequel ledit premier équipement communique.

De préférence, la séquence de symboles prévue pour permettre le réglage de paramètres est une séquence de symboles prévue pour permettre la commande dynamique du gain d'un amplificateur à gain variable d'un récepteur radiofréquence d'un second équipement du système de radiocommunications avec lequel le premier équipement communique.

Dit autrement, lesdits moyens pour émettre sont adaptés pour émettre la séquence d'apprentissage à l'intérieur d'un intervalle de temps réservé dans la structure de trame pour l'émission d'une séquence de CAG, et la séquence d'apprentissage assure en même temps le rôle d'une telle séquence de CAG.

Un troisième aspect de l'invention concerne un terminal mobile d'un système de radiocommunications, comprenant un émetteur radiofréquence ayant un amplificateur radiofréquence et un dispositif de linéarisation de l'amplificateur radiofréquence, qui comprend en outre un dispositif d'apprentissage du dispositif de linéarisation selon le deuxième aspect.

Un quatrième aspect de l'invention concerne une station de base d'un système de radiocommunications, comprenant un émetteur radiofréquence ayant un amplificateur radiofréquence et un dispositif de linéarisation de l'amplificateur radiofréquence, qui comprend en outre un dispositif d'apprentissage du dispositif de linéarisation selon le troisième aspect.

D'autres caractéristiques et avantages de l'invention apparaîtront encore à la lecture de la description qui va suivre. Celle-ci est purement illustrative et doit être lue en regard des dessins annexés sur lesquels :
- la figure 1 est un schéma synoptique d'un exemple de terminal mobile selon l'invention ;
- la figure 2 est un schéma illustrant un premier exemple de salves émises par le terminal mobile, sans séquence de CAG ;
- la figure 3 est un schéma illustrant un second exemple de salves émises par le terminal mobile, avec une séquence de CAG qui selon l'invention comprend une séquence d'apprentissage de linéarisation ;et,
- la figure 4 est un schéma illustrant la mise en oeuvre d'un procédé de CAG entre un premier et un second équipement, et réciproquement.

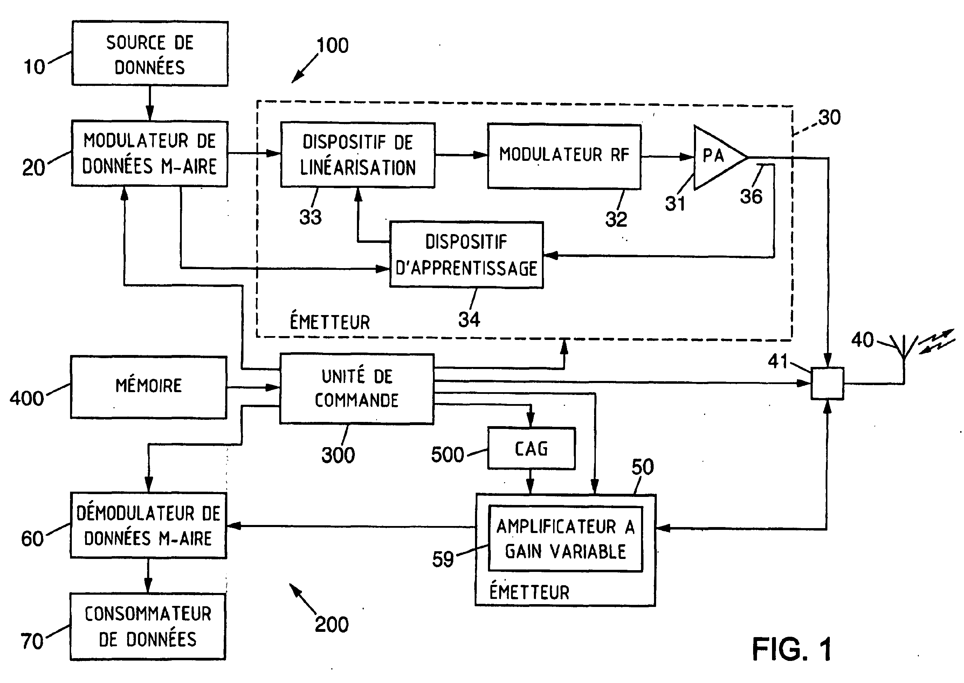

A la figure 1, on a représenté schématiquement les moyens d'un exemple de terminal mobile selon l'invention. Un tel terminal mobile appartient par exemple à un système de radiocommunications qui comprend par ailleurs un réseau fixe ayant des stations de base.

Le terminal comprend une chaîne d'émission 100, une chaîne de réception 200, une unité de commande 300, ainsi qu'une mémoire permanente 400, ainsi qu'un dispositif 500 de commande automatique de gain (CAG) associé à un récepteur RF de la chaîne de réception 200.

La chaîne d'émission 100 comprend une source de données utiles 10, par exemple un codeur de parole délivrant des données codant de la voix. La source 10 est couplée à un modulateur de données M-aire 20 qui assure la modulation en bande de base des données à émettre selon une modulation à M états distincts, où M est un nombre entier déterminé. Les données binaires qu'il reçoit de la source 10 sont traduites par le modulateur 20 en des symboles appartenant à un alphabet M-aire c'est-à-dire comprenant M symboles distincts. La sortie du modulateur 20 est couplée à l'entrée d'un émetteur radiofréquence 30. A partir de la suite des symboles reçus, l'émetteur 30 produit un signal RF convenant pour l'émission radioélectrique via une antenne ou un câble. La sortie de l'émetteur 30 est couplée à une antenne d'émission/réception 40 via un commutateur 41. Ainsi le signal RF produit par l'émetteur est émis sur le canal radio associé à l'émetteur.

La chaîne de réception 200 comprend un récepteur radiofréquence 50 qui est couplé à l'antenne 40 via le commutateur 41, pour recevoir un signal RF. Le récepteur 50 assure la transposition du domaine RF vers la bande de base (conversion descendante). La chaîne de réception 200 comprend aussi un démodulateur de données M-aire 60, couplé au récepteur 50. Le démodulateur de données 60 assure en bande de base la démodulation des données du signal reçu c'est-à-dire l'opération inverse de celle assurée par le modulateur 20. Enfin, la chaîne de réception 200 comprend un dispositif consommateur de données 70, tel qu'un décodeur de parole, qui est couplé au démodulateur 60. Ce dispositif reçoit en entrée les données binaires délivrées par le démodulateur 60.

L'unité 300 est par exemple un microprocesseur ou un microcontrôleur qui assure la gestion du terminal mobile. Notamment, elle commande le modulateur de données 20, le démodulateur de données 60, l'émetteur 30 et le commutateur 41. Elle génère aussi des données de signalisation qui sont fournies au modulateur 20 pour être émises dans des canaux logiques de signalisation appropriés. A l'inverse, l'unité 300 reçoit du démodulateur de données 60 des données de signalisation envoyées par le réseau fixe dans des canaux logiques de signalisation appropriés, notamment des informations de synchronisation et des commandes de fonctionnement.

La mémoire 400, est par exemple une mémoire ROM (« Read Only Memory »), EPROM (« Electrically Programable ROM ») ou Flash-EPROM, dans laquelle sont stockées des données qui sont utilisées pour le fonctionnement du terminal mobile. Ces données comprennent notamment une séquence d'apprentissage de linéarisation sur laquelle on reviendra plus loin.

On va maintenant décrire en détail un exemple de réalisation de l'émetteur 30. Dans cet exemple, l'émetteur 30 comprend un amplificateur de puissance radiofréquence 31, un modulateur radiofréquence 32 qui assure la transposition de la bande de base vers le domaine radiofréquence (conversion montante), un dispositif de linéarisation 33, un module d'apprentissage 34 associé au dispositif de linéarisation.

La sortie de l'amplificateur de puissance 31 délivre le signal RF à émettre. C'est pourquoi elle est couplée à l'antenne 40 via le commutateur 41. L'entrée de l'amplificateur de puissance 31 reçoit un signal radiofréquence délivré par la sortie du modulateur radiofréquence 32. L'entrée de celui-ci est couplée à la sortie du modulateur de données 20 pour recevoir la suite des symboles formant le signal en bande de base à émettre, à travers le dispositif de linéarisation 33. Ce dernier comprend par exemple un dispositif de prédistorsion comprenant une palette (« look-up table » en anglais) qui traduit chaque valeur du signal à émettre en une valeur pré-distordue. En variante ou en complément, le dispositif 33 peut aussi comprendre des moyens d'asservissement en amplitude du signal en sortie de l'émetteur 30.

Le module d'apprentissage 34 réalise l'apprentissage du dispositif de linéarisation 33 en fonction d'un signal d'entrée qui reflète le signal RF délivré par la sortie de l'amplificateur de puissance 31. A cet effet, le module 34 reçoit une partie de ce signal RF, qui est prélevée en sortie de l'amplificateur de puissance 31 au moyen d'un coupleur 36. En tant que de besoin, le module 34 assure le retour en bande de base du signal RF ainsi prélevé. Bien qu'étant représenté entièrement à l'intérieur de l'émetteur 30, le module 34 peut, au moins en partie, être mis en oeuvre par des moyens appartenant à l'unité de commande 300, notamment des moyens logiciels.

Enfin, le dispositif de commande automatique de gain 500 permet à l'unité de commande 300 de faire varier dynamiquement le gain de l'amplificateur à gain variable 59 du récepteur RF 50, en fonction d'informations qui sont reçues de la station de base avec laquelle le terminal communique, selon un procédé connu en lui-même. En vertu de ce procédé, la station de base émet à des instants déterminés une séquence déterminée, appelée séquence de CAG. Cette séquence est connue de et reconnaissable par le terminal mobile. Elle lui permet de mesurer la puissance du signal reçu de la station de base et d'en déduire une commande du gain de l'amplificateur 59. Ce procédé est mis en oeuvre dans le terminal mobile par le dispositif 500 sous la commande de l'unité 300.

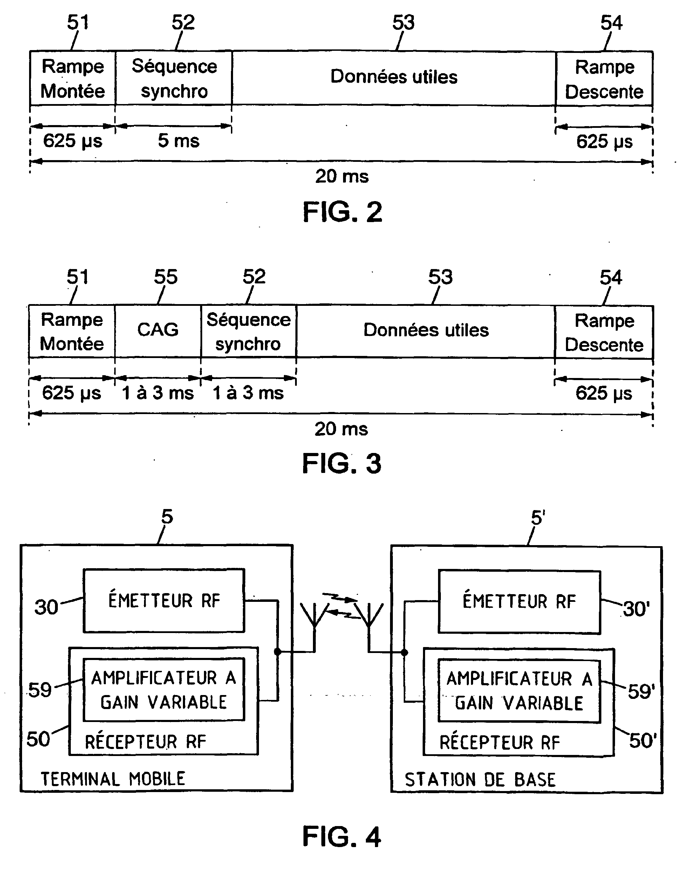

Le principe d'un tel procédé sera décrit plus bas en référence au schéma de la figure 4.

On va maintenant décrire le fonctionnement du terminal mobile pendant une phase d'apprentissage, par le dispositif 34, du dispositif de linéarisation 33. Bien que cela ne soit pas mentionné à chaque fois dans ce qui suit, il est bien entendu que les termes "phase d'apprentissage" et les termes "séquence d'apprentissage" se rapportent à l'apprentissage du dispositif de linéarisation 33 effectué par le dispositif d'apprentissage 34 sous la commande de l'unité 300.

Le procédé d'apprentissage du dispositif 33 comprend une étape consistant à générer une séquence d'apprentissage comportant un nombre N déterminé de symboles, où N est un nombre entier. Cette étape est réalisée par le modulateur de données 20 sous la commande de l'unité de commande 300. A cet effet, l'unité 300 lit une séquence de bits correspondante dans la mémoire 400.

Ensuite, toujours sous la commande de l'unité 300, la séquence d'apprentissage est émise au moyen de l'émetteur 30 dans certaines au moins des salves émises par celui-ci, selon la structure de trame du système.

Le dispositif d'apprentissage 34 obtient alors la séquence d'apprentissage émise et la compare à la séquence d'apprentissage générée, et effectue en conséquence des actions telles que des adaptations de coefficients de prédistorsion ou autres du dispositif de linéarisation 33, selon un algorithme d'apprentissage déterminé. Cet algorithme peut être adaptatif. On parle d'entraînement pour désigner ces opérations.

On peut noter que pour toute modulation, il est possible de trouver une séquence de signal de longueur N déterminée dont les caractéristiques répondent à des contraintes imposées en terme de largeur spectrale, de profondeur de modulation d'amplitude, et/ou autres. Dans un exemple, N est égal à 10.

La séquence de CAG comprend au moins N symboles. Elle peut donc avoir une longueur supérieure à celle de la séquence d'apprentissage, lorsqu'elle comprend plus de N symboles. Dans ce cas, les symboles de la séquence d'apprentissage sont de préférence les symboles de la séquence de CAG qui sont transmis en premier. De cette manière, la convergence de l'algorithme d'apprentissage et donc la linéarisation de l'amplificateur RF sont obtenus au plus vite.

Des phases d'apprentissage peuvent être effectuées de façon périodique ou autre. D'autres contraintes peuvent devoir être prises en compte après la phase d'apprentissage initiale, lorsqu'il convient juste de corriger des dérives de l'émetteur. La séquence d'apprentissage peut donc évoluer tant en contenu qu'en longueur. Le nombre N n'est donc pas forcément fixé d'une émission de la séquence d'apprentissage à une autre. Si une augmentation de la taille de la séquence pose des problèmes (par exemple si la structure de trame est peu flexible), on peut fixer la taille N de la séquence et juste modifier son contenu en fonction de l'évolution des contraintes sur le système.

Le schéma de la figure 2 illustre un premier exemple de salve, qui ne comprend pas de séquence de CAG. Dans cet exemple, la salve a une durée égale à 20 ms. Elle comprend tout d'abord une rampe de montée 51 ("ramping-up" en anglais) de 625 µs, comprenant cinq symboles de bourrage, pour assurer la montée en puissance. Par symboles de bourrage, on entend que les données binaires transmises dans cette rampe de montée sont des bits de bourrage c'est-à-dire, par exemple, une suite de 0. Elle comprend ensuite une séquence de données de synchronisation 52 dont la durée est égale à 5 ms environ. Ensuite, elle comprend une séquence de données utiles 53. Les données utiles peuvent être des données codant de la voix et plus généralement des données de trafic, ou des données de signalisation selon que la salve est émise sur un canal logique de trafic ou un canal logique de signalisation, respectivement. Elle comprend enfin une rampe de descente 54, ayant à nouveau cinq symboles de bourrage pour la descente en puissance. Eventuellement, un temps de garde est en outre prévu après l'émission d'une salve, afin de garantir le retour à la réception de l'émetteur.

En outre, dans toute structure de trame il est prévu d'émettre des salves isolées, notamment à chaque changement de canal logique (se produisant notamment à chaque retournement, c'est-à-dire passage d'une phase de réception à une phase d'émission du terminal), à chaque changement de fréquence RF (lorsqu'une fonctionnalité de saut de fréquence est mise en oeuvre par le système), à chaque changement de palier de puissance d'émission, ou encore dans d'autres cas particuliers qu'il serait trop long de détailler ici.

La figure 3 montre un exemple de telle trame isolée comprenant, avant la séquence de synchronisation 52, une séquence de CAG référencée 55. Cette séquence 55 est émise pour permettre la commande dynamique, par le réseau fixe, de la puissance d'émission de l'émetteur (voir plus haut). Dans cet exemple, la séquence 52 et la séquence 55 ne durent que de 1 à 3 ms chacune. Les autres parties de la salve sont inchangées par rapport à la salve de la figure 2. La séquence de données utiles 53 peut toutefois être plus courte que dans le cas d'une salve normale selon la figure 2.

Avantageusement, on utilise une partie de ces salves isolées pour permettre au dispositif d'apprentissage 34 de l'émetteur radiofréquence 32 d'exécuter un algorithme d'apprentissage du dispositif de linéarisation 33. Dans l'exemple de la figure 3, la séquence de linéarisation est ainsi comprise dans la séquence de CAG précitée.

Il est ainsi possible d'utiliser le temps nécessaire à l'émission de la séquence d'apprentissage à d'autres fins comme par exemple le réglage de la CAG en réception, selon le procédé qui a été évoqué plus haut en regard du schéma de la figure 1.

La séquence de CAG, et donc la séquence d'apprentissage, sont de préférence émises en début de trame, puis lors d'un changement de canal logique, lors d'un changement de fréquence RF et/ou lors d'un changement de palier de puissance et/ou dans d'autres cas qu'il serait trop long de détailler ici. C'est pourquoi il est particulièrement avantageux de combiner ces séquences (la séquence d'apprentissage étant comprise dans la séquence de CAG).

Selon un autre avantage, la séquence de CAG se situe au plus près de la rampe de montée en puissance du signal, par exemple, juste à la suite de cette rampe. De cette manière, l'apprentissage du dispositif de linéarisation peut être réalisé au plus vite et ainsi perturber la transmission le moins longtemps possible.

Il est préférable que la longueur de la séquence d'apprentissage soit telle qu'elle n'occupe pas une trop grande portion de la salve afin de garder un maximum de symboles pour la diffusion d'informations utiles. Cette durée dépend évidemment de la précision recherchée pour l'algorithme d'apprentissage mais un compromis entre précision et durée s'avère souvent nécessaire afin de conserver un maximum d'informations utiles dans la salve. Un compromis raisonnable est atteint lorsqu'elle représente environ 5% de la durée totale de la salve. Dans le cas d'une salve de 20 ms transmise à un taux binaire de 8 ksymboles/s, la durée d'une séquence d'apprentissage de N=10 symboles est ainsi égale à 1,25 ms soit 6,25% de la durée totale de la trame.

Le schéma de la figure 4 illustre la mise en oeuvre d'un procédé de CAG (connu en soi) entre un premier équipement 5 et un second équipement 5' d'un système de radiocommunications.

L'équipement 5 est ici un terminal mobile par exemple tel que décrit plus haut en regard de la figure 1. Il comprend l'émetteur RF 30 et le récepteur RF 50, ce dernier comprenant l'amplificateur à gain variable 59. L'équipement 5' est ici une station de base avec laquelle le terminal mobile 5 communique, qui comprend un émetteur RF 30' et un récepteur RF 50' ayant un amplificateur à gain variable 59'. Fonctionnellement, les composants 30', 50' et 59' de la station de base 5' sont identiques ou comparables aux composants respectivement 30, 50 et 59 du terminal mobile 5'. Ces composants ne sont pas détaillés à nouveau ici.

Une séquence de CAG émise par le terminal mobile 5 permet la commande dynamique du gain de l'amplificateur 59' du récepteur 50' de la station de base 5'. Réciproquement, une séquence de CAG émise par la station de base 5' permet la commande dynamique du gain de l'amplificateur 59 du récepteur 50 du terminal mobile.

## Revendications

1. Procédé d'apprentissage d'un dispositif de linéarisation d'un amplificateur radiofréquence (31) qui est compris dans un émetteur radiofréquence (30) d'un premier équipement (5) d'un système de radiocommunications, lequel émetteur est adapté pour émettre des salves selon une structure de trame déterminée, chaque salve comprenant des symboles appartenant à un alphabet de symboles déterminé, le procédé comprenant les étapes consistant à :
a) générer une séquence d'apprentissage de linéarisation (figure 3) comprenant un nombre déterminé N de symboles, où N est un nombre entier déterminé ;
b) émettre la séquence d'apprentissage de linéarisation au moyen de l'émetteur dans certaines au moins des salves émises par celui-ci ;
c) comparer la séquence d'apprentissage de linéarisation émise à la séquence d'apprentissage de linéarisation générée afin d'entraîner ledit dispositif de linéarisation,
**caractérisé en ce que**, à l'étape b), la séquence d'apprentissage de linéarisation est comprise dans une séquence de symboles prévue en outre pour permettre le réglage de paramètres de la chaîne de transmission entre ledit premier équipement et un second équipement (5') du système de radiocommunications avec lequel ledit premier équipement communique.

2. Procédé selon la revendication 1, suivant lequel la séquence de symboles prévue pour permettre le réglage de paramètres est une séquence de symboles prévue pour permettre la commande dynamique du gain d'un amplificateur à gain variable d'un récepteur radiofréquence d'un second équipement du système de radiocommunications avec lequel le premier équipement communique.

3. Procédé selon la revendication 1 ou la revendication 2, suivant lequel la séquence d'apprentissage de linéarisation n'occupe qu'une partie seulement de la salve dans laquelle elle est émise.

4. Procédé selon la revendication 3, suivant lequel la séquence d'apprentissage de linéarisation occupe environ 5% de la durée de la salve dans laquelle elle est émise.

5. Procédé selon l'une quelconque des revendications précédentes, suivant lequel la séquence d'apprentissage de linéarisation est émise en début de trame.

6. Procédé selon l'une quelconque des revendications précédentes, suivant lequel la séquence d'apprentissage de linéarisation est émise en outre lors d'un changement de canal logique, d'un changement de fréquence et/ou d'un changement de palier de puissance du premier équipement.

7. Procédé selon l'une quelconque des revendications précédentes, suivant lequel la séquence de symboles prévue pour permettre la commande dynamique de la puissance d'émission du terminal mobile comprend plus de N symboles, et suivant lequel lesdits N symboles de la séquence d'apprentissage de linéarisation sont les symboles de la séquence de symboles prévue pour permettre la commande dynamique de la puissance d'émission du terminal mobile qui sont transmis en premier.

8. Dispositif d'apprentissage d'un dispositif de linéarisation (33) d'un amplificateur radiofréquence (31) qui est compris dans un émetteur radiofréquence (30) d'un premier équipement d'un système de radiocommunications, lequel émetteur est adapté pour émettre des salves selon une structure de trame déterminée, chaque salve comprenant des symboles appartenant à un alphabet de symboles déterminé, le dispositif comprenant :
a) des moyens (300,10,20) pour générer une séquence d'apprentissage de linéarisation comprenant un nombre déterminé N de symboles, où N est un nombre entier déterminé ;
b) des moyens (300,30) pour émettre la séquence d'apprentissage de linéarisation au moyen de l'émetteur dans certaines au moins des salves émises par celui-ci ;
c) des moyens (300,34) pour comparer la séquence d'apprentissage de linéarisation émise à la séquence d'apprentissage de linéarisation générée afin d'entraîner ledit dispositif de linéarisation,
**caractérisé en ce que** ladite séquence d'apprentissage de linéarisation est comprise dans une séquence de symboles prévue en outre pour permettre le réglage de paramètres de la chaîne de transmission entre ledit premier équipement et un second équipement (5') du système de radiocommunications avec lequel ledit premier équipement communique.

9. Dispositif selon la revendication 8, dans lequel la séquence de symboles prévue pour permettre le réglage de paramètres est une séquence de symboles prévue pour permettre la commande dynamique du gain d'un amplificateur à gain variable d'un récepteur radiofréquence d'un second équipement du système de radiocommunications avec lequel le premier équipement communique.

10. Dispositif selon la revendication 8 ou la revendication 9, dans lequel la séquence d'apprentissage de linéarisation n'occupe qu'une partie seulement de la salve dans laquelle elle est émise.

11. Dispositif selon la revendication 10, dans lequel la séquence d'apprentissage de linéarisation occupe environ 5% de la durée de la salve dans laquelle elle est émise.

12. Dispositif selon l'une quelconque des revendications 8 à 11, dans lequel lesdits moyens pour émettre sont adaptés pour émettre la séquence d'apprentissage de linéarisation en début de trame.

13. Dispositif selon l'une quelconque des revendications 8 à 12, dans lequel lesdits moyens pour émettre sont adaptés pour émettre en outre la séquence d'apprentissage de linéarisation lors d'un changement de canal logique, d'un changement de fréquence et/ou d'un changement de palier de puissance du terminal mobile.

14. Dispositif selon l'une quelconque des revendications 8 à 13, dans lequel la séquence de symboles prévue pour permettre le réglage de paramètres comprend plus de N symboles, et dans lequel lesdits N symboles de la séquence d'apprentissage de linéarisation sont les symboles de la séquence de symboles prévue pour permettre le réglage de paramètres qui sont transmis en premier.

15. Terminal mobile (5) d'un système de radiocommunications, comprenant un émetteur radiofréquence (30) ayant un amplificateur radiofréquence et un dispositif de linéarisation (33) de l'amplificateur radiofréquence, **caractérisé en ce qu'**il comprend en outre un dispositif d'apprentissage du dispositif de linéarisation selon l'une quelconque des revendications 8 à 14.

16. Station de base (5') d'un système de radiocommunications, comprenant un émetteur radiofréquence (30') ayant un amplificateur radiofréquence et un dispositif de linéarisation de l'amplificateur radiofréquence, **caractérisé en ce qu'**il comprend en outre un dispositif d'apprentissage du dispositif de linéarisation selon l'une quelconque des revendications 8 à 14.

## Patentansprüche

1. Verfahren zum Trainieren einer Vorrichtung zur Linearisierung eines Funkfrequenzverstärkers (31), der in einem Funkfrequenzsender (30) einer ersten Einrichtung (5) eines Funkkommunikationssystems vorgesehen ist, wobei dieser Sender dafür ausgelegt ist, Salven in einer bestimmten Blockstruktur zu senden, wobei jede Salve Symbole umfasst, die zu einem bestimmten Symbolealphabet gehören, wobei das Verfahren die Schritte umfasst, die darin bestehen, dass
a) eine Linearisierungslernsequenz erzeugt wird (Fig. 3), die eine bestimmte Anzahl N von Symbolen umfasst, wobei N eine bestimmte ganze Zahl ist,
b) die Linearisierungslernsequenz mit Hilfe des Senders in mindestens manchen von diesem gesendeten Salven gesendet wird,
c) die gesendete Linearisierungslernsequenz mit der erzeugten Linearisierungslernsequenz verglichen wird, um die Linearisierungsvorrichtung zu trainieren,
**dadurch gekennzeichnet, dass** die Linearisierungslernsequenz im Schritt b) in einer Sequenz von Symbolen enthalten ist, die außerdem dafür vorgesehen ist, die Einstellung von Parametern der Übertragungskette zwischen der ersten Einrichtung und einer zweiten Einrichtung (5') des Funkkommunikationssystems zu gestatten, mit der die erste Einrichtung kommuniziert.

2. Verfahren nach Anspruch 1, bei welchem die Sequenz von Symbolen, die dafür vorgesehen ist, die Einstellung von Parametern zu gestatten, eine Sequenz von Symbolen ist, die dafür vorgesehen ist, die dynamische Steuerung des Gewinns eines Verstärkers mit veränderlichem Gewinn eines Funkfrequenzempfängers einer zweiten Einrichtung des Funkkommunikationssystems zu gestatten, mit der die erste Einrichtung kommuniziert.

3. Verfahren nach Anspruch 1 oder Anspruch 2, bei dem die Linearisierungslernsequenz nur einen Teil der Salve einnimmt, in der sie gesendet wird.

4. Verfahren nach Anspruch 3, bei dem die Linearisierungslernsequenz etwa 5 % der Dauer der Salve, in der sie gesendet wird, einnimmt.

5. Verfahren nach einem der vorhergehenden Ansprüche, bei dem die Linearisierungslernsequenz am Blockanfang gesendet wird.

6. Verfahren nach einem der vorhergehenden Ansprüche, bei dem die Linearisierungslernsequenz außerdem bei einem Wechsel des logischen Kanals, einem Frequenzwechsel und/oder einem Wechsel der Leistungsstufe der ersten Einrichtung gesendet wird.

7. Verfahren nach einem der vorhergehenden Ansprüche, bei welchem die Sequenz von Symbolen, die dafür vorgesehen ist, die dynamische Steuerung der Sendeleistung des mobilen Terminals zu gestatten, mehr als N Symbole umfasst, und bei welchem diese N Symbole der Linearisierungslernsequenz die Symbole der für die dynamische Steuerung der Sendeleistung des mobilen Terminals vorgesehenen Symbolesequenz sind, die als erstes übertragen werden.

8. Vorrichtung zum Trainieren einer Vorrichtung (33) zur Linearisierung eines Funkfrequenzverstärkers (31), der in einem Funkfrequenzsender (30) einer ersten Einrichtung eines Funkkommunikationssystems vorgesehen ist, wobei dieser Sender dafür ausgelegt ist, Salven in einer bestimmten Blockstruktur zu senden, wobei jede Salve Symbole umfasst, die zu einem bestimmten Symbolealphabet gehören, wobei die Vorrichtung umfasst:
a) Mittel (300, 10, 20) zum Erzeugen einer Linearisierungslernsequenz, die eine bestimmte Anzahl N von Symbolen umfasst, wobei N eine bestimmte ganze Zahl
b) Mittel (300, 30) zum Senden der Linearisierungslernsequenz mit Hilfe des Senders in mindestens manchen der von diesem gesendeten Salven,
c) Mittel (300, 34) zum Vergleichen der gesendeten Linearisierungslernsequenz mit der erzeugten Linearisierungslernsequenz, um die Linearisierungsvorrichtung zu trainieren,
**dadurch gekennzeichnet, dass** die Linearisierungslernsequenz in einer Sequenz von Symbolen enthalten ist, die außerdem dafür vorgesehen ist, die Einstellung von Parametern der Übertragungskette zwischen der ersten Einrichtung und einer zweiten Einrichtung (5') des Funkkommunikationssystems zu gestatten, mit der die erste Einrichtung kommuniziert.

9. Vorrichtung nach Anspruch 8, bei der die Sequenz von Symbolen, die dafür vorgesehen ist, die Einstellung von Parametern zu gestatten, eine Sequenz von Symbolen ist, die dafür vorgesehen ist, die dynamische Steuerung des Gewinns eines Verstärkers mit veränderlichem Gewinn eines Funkfrequenzempfängers einer zweiten Einrichtung des Funkkommunikationssystems zu gestatten, mit der die erste Einrichtung kommuniziert.

10. Vorrichtung nach Anspruch 8 oder Anspruch 9, bei der die Linearisierungslernsequenz nur einen Teil der Salve einnimmt, in der sie gesendet wird.

11. Vorrichtung nach Anspruch 10, bei der die Linearisierungslernsequenz etwa 5 % der Dauer der Salve einnimmt, in der sie gesendet wird.

12. Vorrichtung nach einem der Ansprüche 8 bis 11, bei der die Mittel zum Senden dafür ausgelegt sind, die Linearisierungslernsequenz am Blockanfang zu senden.

13. Vorrichtung nach einem der Ansprüche 8 bis 12, bei der die Mittel zum Senden dafür ausgelegt sind, außerdem die Linearisierungslernsequenz bei einem Wechsel des logischen Kanals, einem Frequenzwechsel und/oder einem Wechsel der Leistungsstufe des mobilen Terminals zu senden.

14. Vorrichtung nach einem der Ansprüche 8 bis 13, bei der die Sequenz von Symbolen, die dafür vorgesehen ist, die Einstellung von Parametern zu gestatten, mehr als N Symbole umfasst, und bei der diese N Symbole der Linearisierungslernsequenz die Symbole der für die Einstellung von Parametern vorgesehenen Symbolesequenz sind, die als erstes übertragen werden.

15. Mobiler Terminal (5) eines Funkkommunikationssystems, umfassend einen Funkkommunikationssender (30) mit einem Funkfrequenzverstärker und einer Vorrichtung (33) zur Linearisierung des Funkfrequenzverstärkers, **dadurch gekennzeichnet, dass** er außerdem eine Vorrichtung zum Trainieren der Linearisierungsvorrichtung nach einem der Ansprüche 8 bis 14 umfasst.

16. Basisstation (5') eines Funkkommunikationssystems, umfassend einen Funkfrequenzsender (30') mit einem Funkfrequenzverstärker und einer Vorrichtung zur Linearisierung des Funkfrequenzverstärkers, **dadurch gekennzeichnet, dass** sie außerdem eine Vorrichtung zum Trainieren der Linearisierungsvorrichtung nach einem der Ansprüche 8 bis 14 umfasst.

## Claims

1. A method of training a device for linearizing a radiofrequency amplifier (31) which is included within a radiofrequency transmitter (30) of a first equipment (5) of a radiocommunication system, which transmitter is adapted for transmitting bursts according to a determined frame structure, each burst comprising symbols belonging to a determined alphabet of symbols, the method comprising the steps consisting in:
a) generating a linearization training sequence (Figure 3) comprising a determined number N of symbols, where N is a determined integer;
b) transmitting the linearization training sequence by means of the transmitter in at least certain of the bursts transmitted by the latter;
c) comparing the linearization training sequence transmitted with the linearization training sequence generated so as to teach said linearization device,
**characterized in that**, in step b), the linearization training sequence is included in a sequence of symbols that is further designed to allow the adjusting of parameters of the transmission chain between said first equipment and a second equipment (5') of the radiocommunication system with which said first equipment communicates.

2. The method as claimed in claim 1, wherein the sequence of symbols that is designed to allow the adjusting of parameters is a sequence of symbols that is designed to allow the dynamic control of the gain of a variable-gain amplifier of a radiofrequency receiver of a second equipment of the radiocommunication system with which the first equipment communicates.

3. The method as claimed in claim 1 or claim 2, wherein the linearization training sequence occupies only a part of the burst in which it is transmitted.

4. The method as claimed in claim 3, wherein the linearization training sequence occupies around 5% of the duration of the burst in which it is transmitted.

5. The method as claimed in any one of the preceding claims, wherein the linearization training sequence is transmitted at the start of the frame.

6. The method as claimed in any one of the preceding claims, wherein the linearization training sequence is further transmitted during a change of logical channel, a change of frequency and/or a change of power rating of the first equipment.

7. The method as claimed in any one of the preceding claims, wherein the sequence of symbols that is designed to allow the dynamic control of the transmission power of the mobile terminal comprises more than N symbols, and according to which said N symbols of the linearization training sequence are the symbols of the sequence of symbols that is designed to allow the dynamic control of the transmission power of the mobile terminal which are sent first.

8. A device for training a device (33) for linearizing a radiofrequency amplifier (31) which is included within a radiofrequency transmitter (30) of a first equipment of a radiocommunication system, which transmitter is adapted for transmitting bursts according to a determined frame structure, each burst comprising symbols belonging to a determined alphabet of symbols, the device comprising:
a) means (300, 10, 20) for generating a linearization training sequence comprising a determined number N of symbols, where N is a determined integer;
b) means (300, 30) for transmitting the linearization training sequence by means of the transmitter in at least certain of the bursts transmitted by the latter;
c) means (300, 34) for comparing the linearization training sequence transmitted with the linearization training sequence generated so as to teach said linearization device,
**characterized in that** said linearization training sequence is included in a sequence of symbols that is further designed to allow the adjusting of parameters of the transmission chain between said first equipment and a second equipment (5') of the radiocommunication system with which said first item of equipment communicates.

9. The device as claimed in claim 8, wherein the sequence of symbols that is designed to allow the adjusting of parameters is a sequence of symbols that is designed to allow the dynamic control of the gain of a variable-gain amplifier of a radiofrequency receiver of a second equipment of the radiocommunication system with which the first equipment communicates.

10. The device as claimed in claim 8 or claim 9, wherein the linearization training sequence occupies only a part of the burst in which it is transmitted.

11. The device as claimed in claim 10, wherein the linearization training sequence occupies around 5% of the duration of the burst in which it is transmitted.

12. The device as claimed in any one of claims 8 to 11, wherein said means for transmitting are adapted for transmitting the linearization training sequence at the start of the frame.

13. The device as claimed in any one of claims 8 to 12, wherein said means for transmitting are adapted for transmitting, moreover, the linearization training sequence during a change of logical channel, a change of frequency and/or a change of power rating of the mobile terminal.

14. The device as claimed in any one of claims 8 to 13, wherein the sequence of symbols that is designed to allow the adjusting of parameters comprises more than N symbols, and wherein said N symbols of the linearization training sequence are the symbols of the sequence of symbols that is designed to allow the adjusting of parameters which are sent first.

15. A mobile terminal (5) of a radiocommunication system, comprising a radiofrequency transmitter (30) having a radiofrequency amplifier and a device (33) for linearizing the radiofrequency amplifier, **characterized in that** it further comprises a device for training the linearization device as claimed in any one of claims 8 to 14.

16. A base station (5') of a radiocommunication system comprising a radiofrequency transmitter (30') having a radiofrequency amplifier and a device for linearizing the radiofrequency amplifier, **characterized in that** it further comprises a device for training the linearization device as claimed in any one of claims 8 to 14.
